# EUROPEAN PATENT APPLICATION

(11) **EP 4 629 243 A1**
(43) Date of publication of application: **08.10.2025**
(21) Application number: 25166787.9
(22) Date of filing: 27.03.2025
(51) Int. Cl.: G11C 8/08, G11C 13/00, G11C 16/08, G11C 8/10

(54) **VOLTAGE CONTROL USING TRANSISTOR SENSING**

(30) Priority: 02.04.2024 US 202463573353 P; 25.07.2024 US 202418784841
(71) Applicant: MICRON TECHNOLOGY, INC., Boise, ID 83716-9632 (US)
(72) Inventor: VENTURINI, Michele Maria, Boise, 83716-9632 (US); MARTINELLI, Andrea, Boise, 83716-9632 (US)
(74) Representative: Marks & Clerk LLP

(57) **Abstract**

Methods, systems, and devices for voltage control using transistor sensing are described. A memory device may support a decoding architecture including one or more sensing transistors that may sense a voltage supplied to word lines of the memory device. For example, the decoding architecture may include a set of transistors configured to drive voltage to the word lines, and the one or more sensing transistors may sense an actual voltage received at the word lines (e.g., after activating the set of transistors). The decoding architecture may also include an amplifier which may receive the actual voltage from the one or more sensing transistors and a target voltage associated with activating the word lines. The amplifier may output a voltage indicative of the difference between the actual voltage and the desired voltage to a charging transistor configured to provide a voltage to a set of transistors for activating the word lines.

## Description

### CROSS REFERENCE

The present Application for Patent claims priority to U.S. Patent Application No. 18/784,841 by Venturini et al., entitled "VOLTAGE CONTROL USING TRANSISTOR SENSING," filed July 25, 2024, and U.S. Patent Application No. 63/573,353 by Venturini et al., entitled "VOLTAGE CONTROL USING TRANSISTOR SENSING," filed April 02, 2024, each of which is assigned to the assignee hereof.

### TECHNICAL FIELD

The following relates to one or more systems for memory, including voltage control using transistor sensing.

### BACKGROUND

Memory devices are widely used to store information in devices such as computers, user devices, wireless communication devices, cameras, digital displays, and others. Information is stored by programming memory cells within a memory device to various states. For example, binary memory cells may be programmed to one of two supported states, often denoted by a logic 1 or a logic 0. In some examples, a single memory cell may support more than two states, any one of which may be stored. To access the stored information, the memory device may read (e.g., sense, detect, retrieve, determine) states from the memory cells. To store information, the memory device may write (e.g., program, set, assign) states to the memory cells.

Various types of memory devices exist, including magnetic hard disks, random access memory (RAM), read-only memory (ROM), dynamic RAM (DRAM), synchronous dynamic RAM (SDRAM), static RAM (SRAM), ferroelectric RAM (FeRAM), magnetic RAM (MRAM), resistive RAM (RRAM), flash memory, phase change memory (PCM), self-selecting memory, chalcogenide memory technologies, not-or (NOR) and not-and (NAND) memory devices, and others. Memory cells may be described in terms of volatile configurations or non-volatile configurations. Memory cells configured in a non-volatile configuration may maintain stored logic states for extended periods of time even in the absence of an external power source. Memory cells configured in a volatile configuration may lose stored states when disconnected from an external power source.

### BRIEF DESCRIPTION OF THE DRAWINGS

FIG. 1 shows an example of a memory array that supports voltage control using transistor sensing in accordance with examples as disclosed herein.
FIGs. 2A, 2B, and 2C show an example of a memory array that supports voltage control using transistor sensing in accordance with examples as disclosed herein.
FIG. 3 shows an example of a circuit that supports voltage control using transistor sensing in accordance with examples as disclosed herein.
FIGs. 4A and 4B show an example of a decoding architecture that supports voltage control using transistor sensing in accordance with examples as disclosed herein.
FIGs. 5A and 5B show an example of a decoding architecture that supports voltage control using transistor sensing in accordance with examples as disclosed herein.
FIG. 6 shows a block diagram of a memory device that supports voltage control using transistor sensing in accordance with examples as disclosed herein.
FIG. 7 shows a flowchart illustrating a method or methods that support voltage control using transistor sensing in accordance with examples as disclosed herein.

### DETAILED DESCRIPTION

In some memory devices, accessing one or more memory cells of the memory device may include activating a word line coupled with the one or more memory cells. Activating the word line may include applying a voltage to the word line via decoding circuitry coupled with the word line. The voltage may be applied to a gate of a transistor (e.g., a charging transistor), and the decoding circuitry may be configured to receive a portion of the voltage via a drain of the transistor. In some cases, the voltage may drop across the transistor due to a configuration of the transistor (e.g., a threshold voltage of the transistor), resulting in a lower voltage received at the decoding circuitry and the word line than planned for. Additionally, or alternatively, the word line may experience variable current demand based on, for example, memory cell leakage over time or during memory cell switching events. However, the transistor may be configured to provide a static current, such that if a voltage drop across the transistor is greater than a threshold voltage (e.g., an activation voltage) of the transistor, the voltage received at the word line may not reach a desired threshold (e.g., an activation threshold). In some such cases, implementing such a decoding architecture may cause decreased reliability for accessing the memory cells of the memory device, resulting in power inefficiencies associated with operating the memory device.

In accordance with examples as described herein, a memory device may support a decoding architecture in which one or more sensing transistors may be implemented to sense a voltage supplied to one or more word lines of the memory device. For example, the decoding architecture may include a set of transistors configured to drive a target activation voltage to the word lines, and the one or more sensing transistors may sense the actual voltage received at the word lines (e.g., after activating the set of transistors). The decoding architecture may also include an amplifier which may receive the actual word line voltage from the one or more sensing transistors and a target (e.g., desired) voltage associated with activating the word lines. The amplifier may output a delta voltage indicative of the difference between the actual word line voltage and the target voltage to a charging transistor. The charging transistor may provide the delta voltage to the set of transistors for activating the word lines. For example, the charging transistor may receive a supply voltage at a source of the charging transistor, and the delta voltage at a gate of the charging transistor, such that the drain of the charging transistor may carry the resulting voltage to the set of transistors for activating the word lines. Implementing the one or more sensing transistors and the amplifier may decrease disparity between the actual voltage received at the word lines and the target voltage for activating the word lines. Likewise, the decoding architecture may support increased reliability for accessing the memory cells of the memory device, resulting in relatively increased power efficiency associated with operating the memory device, among other advantages.

In addition to applicability in memory systems as described herein, techniques for voltage control using transistor sensing may be generally implemented to improve the performance of various electronic devices and systems (including artificial intelligence (AI) applications, augmented reality (AR) applications, virtual reality (VR) applications, and gaming). Some electronic device applications, including high-performance applications such as AI, AR, VR, and gaming, may be associated with relatively high processing requirements to satisfy user expectations. As such, increasing processing capabilities of the electronic devices by decreasing response times, improving power consumption, reducing complexity, increasing data throughput or access speeds, decreasing communication times, or increasing memory capacity or density, among other performance indicators, may improve user experience or appeal. Implementing the techniques described herein may improve the performance of electronic devices by increasing reliability for accessing memory cells of the memory device, which may improve power efficiency and overall user experience, among other benefits.

In addition to applicability in memory systems as described herein, techniques for voltage control using transistor sensing may be generally implemented to improve the sustainability of various electronic devices and systems. As the use of electronic devices has become even more widespread, the quantity of energy used and harmful emissions associated with production of electronic devices and device operation has increased. Further, the amount of waste (e.g., electronic waste) associated with disposal of electronic devices may also pose environmental concerns. Implementing the techniques described herein may improve the impact related to electronic devices by improving power efficiency, which may result in lower power consumption, among other benefits.

Features of the disclosure are illustrated and described in the context of memory devices and arrays. Features of the disclosure are further illustrated and described in the context of circuits, decoding architectures, and flowcharts.

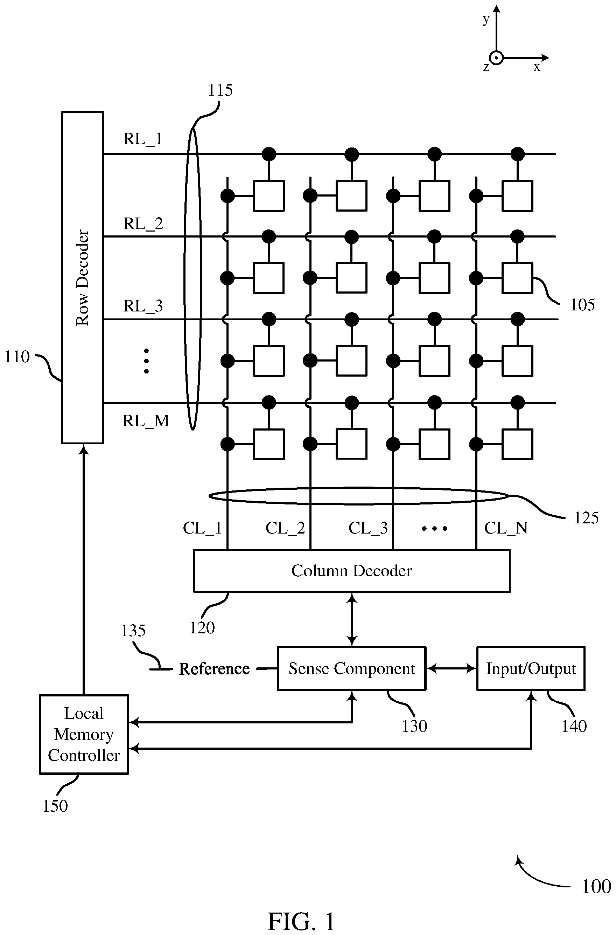

**FIG. 1** shows an example of a memory device 100 that supports voltage control using transistor sensing in accordance with examples as disclosed herein. In some examples, the memory device 100 may be referred to as or include a memory die, a memory chip, or an electronic memory apparatus. The memory device 100 may be operable to provide locations to store information (e.g., physical memory addresses) that may be used by a system (e.g., a host device coupled with the memory device 100, for writing information, for reading information).

The memory device 100 may include one or more memory cells 105 that each may be programmable to store different logic states (e.g., a programmed one of a set of two or more possible states). For example, a memory cell 105 may be operable to store one bit of information at a time (e.g., a logic 0 or a logic 1). In some examples, a memory cell 105 (e.g., a multi-level memory cell 105) may be operable to store more than one bit of information at a time (e.g., a logic 00, logic 01, logic 10, a logic 11). In some examples, the memory cells 105 may be arranged in an array.

A memory cell 105 may store a logic state using a configurable material, which may be referred to as a memory element, a storage element, a memory storage element, a material element, a material memory element, a material portion, or a polarity-written material portion, among others. A configurable material of a memory cell 105 may refer to a chalcogenide-based storage component. For example, a chalcogenide storage element may be used in a phase change memory cell, a thresholding memory cell, or a self-selecting memory cell, among other architectures.

In some examples, the material of a memory cell 105 may include a chalcogenide material or other alloy including selenium (Se), tellurium (Te), arsenic (As), antimony (Sb), carbon (C), germanium (Ge), silicon (Si), or indium (In), or various combinations thereof. In some examples, a chalcogenide material having primarily selenium (Se), arsenic (As), and germanium (Ge) may be referred to as a SAG-alloy. In some examples, a SAG-alloy may also include silicon (Si) and such chalcogenide material may be referred to as SiSAG-alloy. In some examples, SAG-alloy may include silicon (Si) or indium (In) or a combination thereof and such chalcogenide materials may be referred to as SiSAG-alloy or InSAG-alloy, respectively, or a combination thereof. In some examples, the chalcogenide material may include additional elements such as hydrogen (H), oxygen (O), nitrogen (N), chlorine (Cl), or fluorine (F), each in atomic or molecular forms.

In some examples, a memory cell 105 may be an example of a phase change memory cell. In such examples, the material used in the memory cell 105 may be based on an alloy (such as the alloys listed above) and may be operated so as to change to different physical state (e.g., undergo a phase change) during normal operation of the memory cell 105. For example, a phase change memory cell 105 may be associated with a relatively disordered atomic configuration (e.g., a relatively amorphous state) and a relatively ordered atomic configuration (e.g., a relatively crystalline state). A relatively disordered atomic configuration may correspond to a first logic state (e.g., a RESET state, a logic 0) and a relatively ordered atomic configuration may correspond to a second logic state (e.g., a logic state different than the first logic state, a SET state, a logic 1).

In some examples (e.g., for thresholding memory cells 105, for self-selecting memory cells 105), some or all of the set of logic states supported by the memory cells 105 may be associated with a relatively disordered atomic configuration of a chalcogenide material (e.g., the material in an amorphous state may be operable to store different logic states). In some examples, the storage element of a memory cell 105 may be an example of a self-selecting storage element. In such examples, the material used in the memory cell 105 may be based on an alloy (e.g., such as the alloys listed above) and may be operated so as to undergo a change to a different physical state during normal operation of the memory cell 105. For example, a self-selecting or thresholding memory cell 105 may have a high threshold voltage state and a low threshold voltage state, where a corresponding "threshold voltage" may refer to a voltage at which or above which the memory cell 105 transitions from a relatively higher-resistance (e.g., non-conductive) state to a relatively lower-resistance (e.g., conductive) state, such as in response to an applied voltage. A high threshold voltage state may correspond to a first logic state (e.g., a RESET state, a logic 0) and a low threshold voltage state may correspond to a second logic state (e.g., a logic state different than the first logic state, a SET state, a logic 1).

During a write operation (e.g., a programming operation) of a self-selecting or thresholding memory cell 105, a polarity used for a write operation may influence (e.g., determine, set, program) a behavior or characteristic of the material of the memory cell 105, such as a thresholding characteristic (e.g., a threshold voltage) of the material. A difference between thresholding characteristics (e.g., resistivity characteristics, conductivity characteristics) of the material of the memory cell 105 for different logic states stored by the material of the memory cell 105 (e.g., a difference between threshold voltages when the material is storing a logic state '0' versus a logic state '1') may correspond to the read window of the memory cell 105.

The memory device 100 may include access lines (e.g., row lines 115 each extending along an illustrative x-direction, column lines 125 each extending along an illustrative y-direction) arranged in a pattern, such as a grid-like pattern. Access lines may be formed with one or more conductive materials. In some examples, row lines 115, or some portion thereof, may be referred to as word lines. In some examples, column lines 125, or some portion thereof, may be referred to as digit lines or bit lines. References to access lines, or their analogues, are interchangeable without loss of understanding. Memory cells 105 may be positioned at intersections of access lines, such as row lines 115 and the column lines 125. In some examples, memory cells 105 may also be arranged (e.g., addressed) along an illustrative z-direction, such as in an implementation of sets of memory cells 105 being located at different levels (e.g., layers, decks, planes, tiers) along the illustrative z-direction. In some examples, a memory device 100 that includes memory cells 105 at different levels may be supported by a different configuration of access lines, decoders, and other supporting circuitry than shown.

Operations such as read operations and write operations may be performed on the memory cells 105 by activating access lines such as one or more of a row line 115 or a column line 125, among other access lines associated with alternative configurations. For example, by activating a row line 115 and a column line 125 (e.g., applying a voltage to the row line 115 or the column line 125), a memory cell 105 may be accessed in accordance with their intersection. An intersection of a row line 115 and a column line 125, among other access lines, in various two-dimensional or three-dimensional configuration may be referred to as an address of a memory cell 105. In some examples, an access line may be a conductive line coupled with a memory cell 105 and may be used to perform access operations on the memory cell 105. In some examples, the memory device 100 may perform operations responsive to commands, which may be issued by a host device coupled with the memory device 100 or may be generated by the memory device 100 (e.g., by a local memory controller 150).

Accessing the memory cells 105 may be controlled through one or more decoders, such as a row decoder 110 or a column decoder 120, among other examples. For example, a row decoder 110 may receive a row address from the local memory controller 150 and activate a row line 115 based on the received row address. A column decoder 120 may receive a column address from the local memory controller 150 and may activate a column line 125 based on the received column address.

The sense component 130 may be operable to detect a state (e.g., a material state, a resistance state, a threshold state) of a memory cell 105 and determine a logic state of the memory cell 105 based on the detected state. The sense component 130 may include one or more sense amplifiers to convert (e.g., amplify) a signal resulting from accessing the memory cell 105 (e.g., a signal of a column line 125 or other access line). The sense component 130 may compare a signal detected from the memory cell 105 to a reference 135 (e.g., a reference voltage, a reference charge, a reference current). The detected logic state of the memory cell 105 may be provided as an output of the sense component 130 (e.g., to an input/output component 140), and may indicate the detected logic state to another component of the memory device 100 or to a host device coupled with the memory device 100.

The local memory controller 150 may control the accessing of memory cells 105 through the various components (e.g., a row decoder 110, a column decoder 120, a sense component 130, among other components). In some examples, one or more of a row decoder 110, a column decoder 120, and a sense component 130 may be co-located with the local memory controller 150. The local memory controller 150 may be operable to receive information (e.g., commands, data) from one or more different controllers (e.g., an external memory controller associated with a host device, another controller associated with the memory device 100), translate the information into a signaling that can be used by the memory device 100, perform one or more operations on the memory cells 105 and communicate data from the memory device 100 to a host device based on performing the one or more operations. The local memory controller 150 may generate row address signals and column address signals to activate access lines such as a target row line 115 and a target column line 125. The local memory controller 150 also may generate and control various signals (e.g., voltages, currents) used during the operation of the memory device 100. In general, the amplitude, the shape, or the duration of an applied signal discussed herein may be varied and may be different for the various operations discussed in operating the memory device 100.

The local memory controller 150 may be operable to perform one or more access operations on one or more memory cells 105 of the memory device 100. Examples of access operations may include a write operation, a read operation, a refresh operation, a precharge operation, or an activate operation, among others. In some examples, access operations may be performed by or otherwise coordinated by the local memory controller 150 in response to access commands (e.g., from a host device). The local memory controller 150 may be operable to perform other access operations not listed here or other operations related to the operating of the memory device 100 that are not directly related to accessing the memory cells 105.

The memory device 100 may include any quantity of non-transitory computer readable media that support voltage control using transistor sensing. For example, a local memory controller 150, a row decoder 110, a column decoder 120, a sense component 130, or an input/output component 140, or any combination thereof may include or may access one or more non-transitory computer readable media storing instructions (e.g., firmware) for performing the functions ascribed herein to the memory device 100. For example, such instructions, if executed by the memory device 100, may cause the memory device 100 to perform one or more associated functions as described herein.

In accordance with examples as described herein, the memory device 100 may support a decoding architecture in which one or more sensing transistors may be implemented to sense a voltage supplied to word lines (e.g., row lines 115). For example, the decoding architecture may include a set of transistors configured to drive voltage to the word lines, and the one or more sensing transistors may sense the actual voltage at the word lines (e.g., after activating the set of transistors). The sensing transistors, the set of transistors, or both may be thin film transistors (TFTs), or other types of transistors. The decoding architecture may also include an amplifier which may receive the actual voltage from the one or more sensing transistors and a target voltage associated with activating the word lines. The amplifier may output a delta voltage indicative of the difference between the actual voltage and the target voltage to a charging transistor configured to provide a resulting voltage to the set of transistors for activating the word lines. For example, the charging transistor may receive a supply voltage at a source of the charging transistor, and the delta voltage at a gate of the charging transistor, such that the drain of the charging transistor may carry the resulting voltage to the set of transistors for activating the word lines. Implementing the one or more sensing transistors and the amplifier may decrease the disparity between the actual voltage received at the word lines and the desired voltage associated with activating the word lines. Likewise, the decoding architecture may support increased reliability for accessing the memory cells 105 of the memory device 100, resulting in relatively increased power efficiency associated with operating the memory device 100.

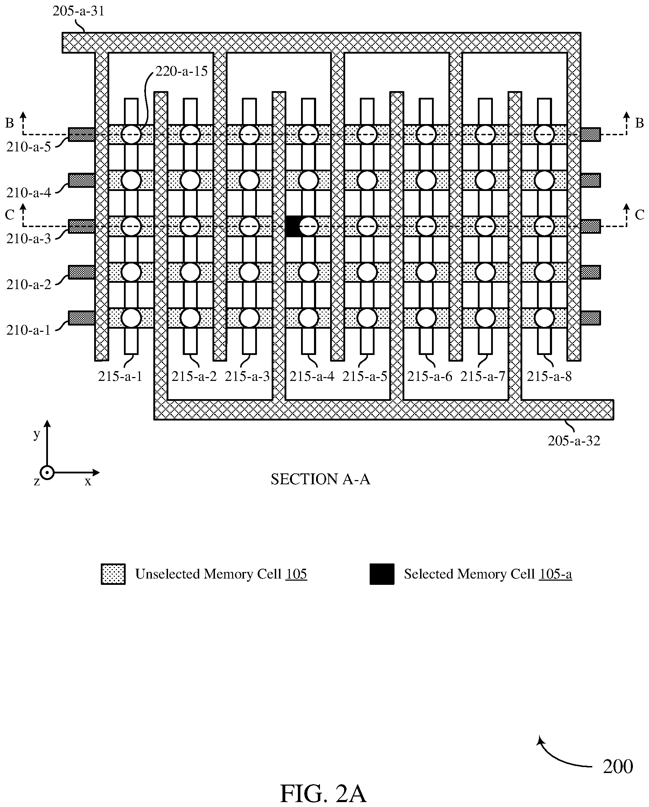

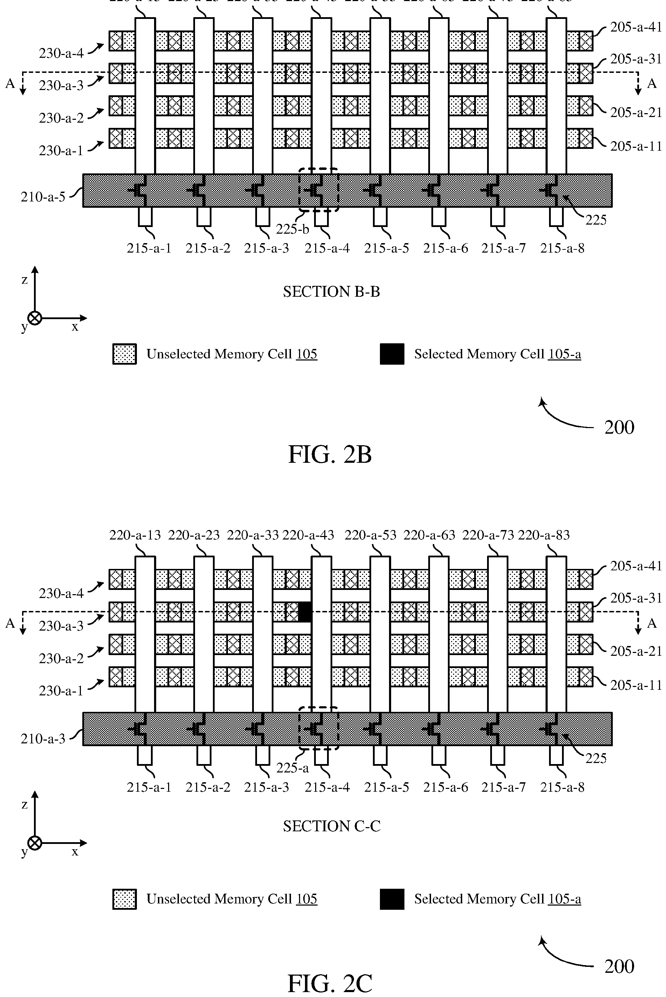

**FIGs. 2A****,** **2B**, and **2C** show examples of a memory array 200 that supports voltage control using transistor sensing in accordance with examples as disclosed herein. The memory array 200 may be included in a memory device 100, and illustrates an example of a three-dimensional arrangement of memory cells 105 that may be accessed by various conductive structures (e.g., access lines). FIG. 2A illustrates a top section view (e.g., SECTION A-A) of the memory array 200 relative to a cut plane A-A as shown in FIGs. 2B and 2C. FIG. 2B illustrates a side section view (e.g., SECTION B-B) of the memory array 200 relative to a cut plane B-B as shown in FIG. 2A. FIG. 2C illustrates a side section view (e.g., SECTION C-C) of the memory array 200 relative to a cut plane C-C as shown in FIG. 2A. The section views may be examples of cross-sectional views of the memory array 200 with some aspects (e.g., dielectric structures) removed for clarity. Elements of the memory array 200 may be described relative to an x-direction, a y-direction, and a z-direction, as illustrated in each of FIGs. 2A, 2B, and 2C. Although some elements included in FIGs. 2A, 2B, and 2C are labeled with a numeric indicator, other corresponding elements are not labeled, although they are the same or would be understood to be similar, in an effort to increase visibility and clarity of the depicted features. Further, although some quantities of repeated elements are shown in the illustrative example of memory array 200, techniques in accordance with examples as described herein may be applicable to any quantity of such elements, or ratios of quantities between one repeated element and another.

In the example of memory array 200, memory cells 105 and word lines 205 may be distributed along the z-direction according to levels 230 (e.g., decks, layers, planes, tiers, as illustrated in FIGs. 2B and 2C). In some examples, the z-direction may be orthogonal to a substrate (not shown) of the memory array 200, which may be below the illustrated structures along the z-direction. Although the illustrative example of memory array 200 includes four levels 230, a memory array 200 in accordance with examples as disclosed herein may include any quantity of one or more levels 230 (e.g., 64 levels, 128 levels) along the z-direction.

Each word line 205 may be an example of a portion of an access line that is formed by one or more conductive materials (e.g., one or more metal portions, one or more metal alloy portions). As illustrated, a word line 205 may be formed in a comb structure, including portions (e.g., projections, tines) extending along the y-direction through gaps (e.g., alternating gaps) between pillars 220. For example, as illustrated, the memory array 200, may include two word lines 205 per level 230 (e.g., according to odd word lines 205-a-*n*1 and even word lines 205-a-*n*2 for a given level, n), where such word lines 205 of the same level 230 may be described as being interleaved (e.g., with portions of an odd word line 205-a-*n*1 projecting along the y-direction between portions of an even word line 205-a-*n*2, and vice versa). In some examples, an odd word line 205 (e.g., of a level 230) may be associated with a first memory cell 105 on a first side (e.g., along the x-direction) of a given pillar 220 and an even word line (e.g., of the same level 230) may be associated with a second memory cell 105 on a second side (e.g., along the x-direction, opposite the first memory cell 105) of the given pillar 220. Thus, in some examples, memory cells 105 of a given level 230 may be addressed (e.g., selected, activated) in accordance with an even word line 205 or an odd word line 205.

Each pillar 220 may be an example of a portion of an access line (e.g., a conductive pillar portion) that is formed by one or more conductive materials (e.g., one or more metal portions, one or more metal alloy portions). As illustrated, the pillars 220 may be arranged in a two-dimensional array (e.g., in an xy-plane) having a first quantity of pillars 220 along a first direction (e.g., eight pillars along the x-direction, eight rows of pillars), and having a second quantity of pillars 220 along a second direction (e.g., five pillars along the y-direction, five columns of pillars). Although the illustrative example of memory array 200 includes a two-dimensional arrangement of eight pillars 220 along the x-direction and five pillars 220 along the y-direction, a memory array 200 in accordance with examples as disclosed herein may include any quantity of pillars 220 along the x-direction and any quantity of pillars 220 along the y-direction. Further, as illustrated, each pillar 220 may be coupled with a respective set of memory cells 105 (e.g., along the z-direction, one or more memory cells 105 for each level 230). A pillar 220 may have a cross-sectional area in an xy-plane that extends along the z-direction. Although illustrated with a circular cross-sectional area in the xy-plane, a pillar 220 may be formed with a different shape, such as having an elliptical, square, rectangular, polygonal, or other cross-sectional area in an xy-plane.

The memory cells 105 each may include a chalcogenide material. In some examples, the memory cells 105 may be examples of thresholding memory cells. Each memory cell 105 may be accessed (e.g., addressed, selected) according to an intersection between a word line 205 (e.g., a level selection, which may include an even or odd selection within a level 230) and a pillar 220. For example, as illustrated, a selected memory cell 105-a of the level 230-a-3 may be accessed according to an intersection between the pillar 220-a-43 and the word line 205-a-32.

A memory cell 105 may be accessed (e.g., written to, read from) by applying an access bias (e.g., an access voltage, V_{access}, which may be a positive voltage or a negative voltage) across the memory cell 105. In some examples, an access bias may be applied by biasing a selected word line 205 with a first voltage (e.g., V_{access}/2) and by biasing a selected pillar 220 with a second voltage (e.g., -V_{access}/2), which may have an opposite sign relative to the first voltage. Regarding the selected memory cell 105-a, a corresponding access bias (e.g., the first voltage) may be applied to the word line 205-a-32, while other unselected word lines 205 may be grounded (e.g., biased to 0V). In some examples, a word line bias may be provided by a word line driver (not shown) coupled with one or more of the word lines 205.

To apply a corresponding access bias (e.g., the second voltage) to a pillar 220, the pillars 220 may be configured to be selectively coupled with a sense line 215 (e.g., a digit line, a column line, an access line extending along the y-direction) via a respective transistor 225 coupled between (e.g., physically, electrically) the pillar 220 and the sense line 215. In some examples, the transistors 225 may be vertical transistors (e.g., transistors having a channel along the z-direction, transistors having a semiconductor junction along the z-direction), which may be formed above the substrate of the memory array 200 using various techniques (e.g., thin film techniques). In some examples, a selected pillar 220, a selected sense line 215, or a combination thereof may be an example of a selected column line 125 described with reference to FIG. 1 (e.g., a bit line).

The transistors 225 (e.g., a channel portion of the transistors 225) may be activated by gate lines 210 (e.g., activation lines, selection lines, a row line, an access line extending along the x-direction) coupled with respective gates of a set of the transistors 225 (e.g., a set along the x-direction). In other words, each of the pillars 220 may have a first end (e.g., towards the negative z-direction, a bottom end) configured for coupling with an access line (e.g., a sense line 215). In some examples, the gate lines 210, the transistors 225, or both may be considered to be components of a row decoder 110 (e.g., as pillar decoder components). In some examples, the selection of (e.g., biasing of) pillars 220, or sense lines 215, or various combinations thereof, may be supported by a column decoder 120, or a sense component 130, or both.

To apply the corresponding access bias (e.g., -V_{access}/2) to the pillar 220-a-43, the sense line 215-a-4 may be biased with the access bias, and the gate line 210-a-3 may be grounded (e.g., biased to 0V) or otherwise biased with an activation voltage. In an example where the transistors 225 are n-type transistors, the gate line 210-a-3 being biased with a voltage that is relatively higher than the sense line 215-a-4 may activate the transistor 225-a (e.g., cause the transistor 225-a to operate in a conducting state), thereby coupling the pillar 220-a-43 with the sense line 215-a-4 and biasing the pillar 220-a-43 with the associated access bias. However, the transistors 225 may include different channel types, or may be operated in accordance with different biasing schemes, to support various access operations.

In some examples, unselected pillars 220 of the memory array 200 may be electrically floating when the transistor 225-a is activated, or may be coupled with another voltage source (e.g., grounded, via a high-resistance path, via a leakage path) to avoid a voltage drift of the pillars 220. For example, a ground voltage being applied to the gate line 210-a-3 may not activate other transistors coupled with the gate line 210-a-3, because the ground voltage of the gate line 210-a-3 may not be greater than the voltage of the other sense lines 215 (e.g., which may be biased with a ground voltage or may be floating). Further, other unselected gate lines 210, including gate line 210-a-5 as shown in FIG. 2B, may be biased with a voltage equal to or similar to an access bias (e.g., -V_{access}/2, or some other negative bias or bias relatively near the access bias voltage), such that transistors 225 along an unselected gate line 210 are not activated. Thus, the transistor 225-b coupled with the gate line 210-a-5 may be deactivated (e.g., operating in a non-conductive state), thereby isolating the voltage of the sense line 215-a-4 from the pillar 220-a-45, among other pillars 220.

In a write operation, a memory cell 105 may be written to by applying a write bias (e.g., where V_{access} = V_{write}, which may be a positive voltage or a negative voltage) across the memory cell 105. In some examples, a polarity of a write bias may influence (e.g., determine, set, program) a behavior or characteristic of the material of the memory cell 105, such as the threshold voltage of the material. For example, applying a write bias with a first polarity may set the material of the memory cell 105 with a first threshold voltage, which may be associated with storing a logic 0. Further, applying a write bias with a second polarity (e.g., opposite the first polarity) may set the material of the memory cell with a second threshold voltage, which may be associated with storing a logic 1. A difference between threshold voltages of the material of the memory cell 105 for different logic states stored by the material of the memory cell 105 (e.g., a difference between threshold voltages when the material is storing a logic state '0' versus a logic state '1') may correspond to the read window of the memory cell 105.

In a read operation, a memory cell 105 may be read from by applying a read bias (e.g., where V_{access} = V_{read}, which may be a positive voltage or a negative voltage) across the memory cell 105. In some examples, a logic state of the memory cell 105 may be evaluated based on whether the memory cell 105 thresholds (e.g., transitions to a relatively lower-resistance or conductive state, permits current) in the presence of the applied read bias. For example, such a read bias may cause a memory cell 105 storing a first logic state (e.g., a logic 0) to threshold (e.g., permit a current flow, permit a current above a threshold current), and may not cause a memory cell 105 storing a second logic state (e.g., a logic 1) to threshold (e.g., may not permit a current flow, may permit a current below a threshold current).

In accordance with examples as described herein, the memory array 200 may support a decoding architecture in which one or more of the transistors 225 may be implemented to sense a voltage supplied to the word lines 205. For example, the decoding architecture may include the transistors 225 which may be configured to drive voltage to the word lines 205, and one or more of the transistors 225 may be configured to operate as sensing transistors for sensing the actual voltage at the word lines 205 (e.g., after activating the set of transistors). The transistors 225 and the one or more sensing transistors may be thin film transistors (TFTs), or other types of transistors. The transistors 225 may be positioned above CMOS circuitry configured to further support the decoding architecture. Likewise, the transistors 225 may be positioned adjacent to a staircase region of the memory array 200 also including circuitry configured to support the transistors 225.

The decoding architecture may also include an amplifier which may receive the actual voltage from the one or more sensing transistors and a target voltage associated with activating the word lines 205. The amplifier may output a delta voltage indicative of the difference between the actual voltage and the target voltage to a charging transistor configured to provide a resulting voltage to the transistors 225 for activating the word lines 205. For example, the charging transistor may receive a supply voltage at a source of the charging transistor, and the delta voltage at a gate of the charging transistor, such that the drain of the charging transistor may carry the resulting voltage to the transistors 225 for activating the word lines 205. Implementing the one or more sensing transistors and the amplifier may decrease the disparity between the actual voltage received at the word lines 205 and the desired voltage associated with activating the word lines 205. Likewise, the decoding architecture may support increased reliability for accessing the memory cells 105 of the memory array 200, resulting in relatively increased power efficiency associated with operating the memory array 200.

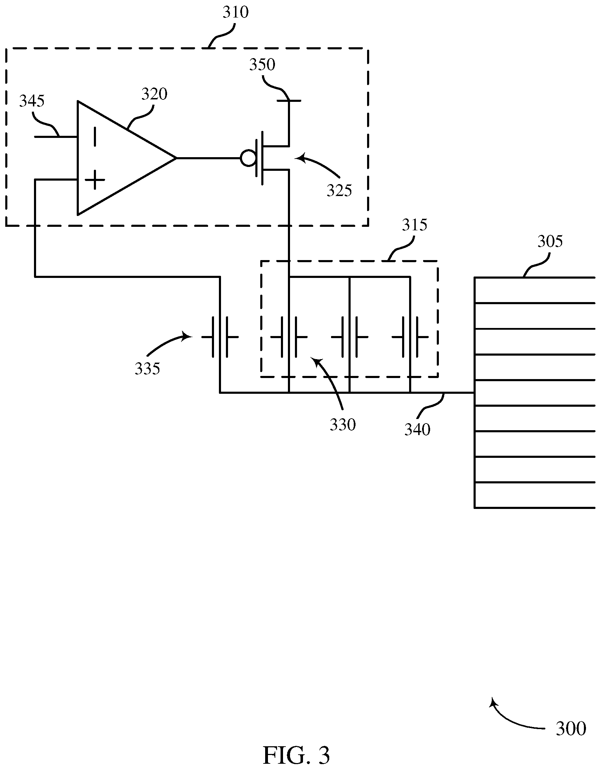

**FIG. 3** shows an example of a circuit 300 that supports voltage control using transistor sensing in accordance with examples as disclosed herein. The circuit 300 may illustrate aspects or operations of a memory device, which may be an example of a memory device 100 as described with reference to FIG. 1. For example, the circuit 300 may illustrate operations associated with activating one or more word lines 305, which may be examples of word lines 205, as described with reference to FIGs. 2A, 2B, and 2C. The circuit 300 illustrates circuit elements associated with a decoding architecture for accessing memory cells of a memory device.

The circuit 300 may include one or more word lines 305 coupled with a set of memory cells. The one or more word lines 305 may be operable to activate the set of memory cells based on activating the one or more word lines 305 with a voltage (e.g., an activation voltage). For example, activating the one or more word lines 305 may facilitate access operations (e.g., read operations, write operations) on the set of memory cells. In some examples, the one or more word lines 305 may be a word line comb, as described in further detail elsewhere herein, including with reference to FIGs. 2A, 2B, and 2C.

The circuit 300 may include decoding circuitry associated with activating the one or more word lines 305. The decoding circuitry may include a first stage 310 and a second stage 315. The first stage 310 may include an amplifier 320 and a charging transistor 325. The second stage 315 may include a set of transistors 330 associated with activating the one or more word lines 305. For example, the transistors 330 may be configured to receive a voltage supplied from the charging transistor 325 and supply the voltage to the one or more word lines 305. In some examples, to activate the one or more word lines 305, one or more transistors 330 of the set of transistors 330 may be activated by a voltage, such that when the voltage reaches a threshold voltage of the one or more transistors 330, the one or more transistors 330 may supply the voltage to the one or more word lines 305. In some such examples, the one or more transistors 330 may supply a portion of the voltage to the word lines 305 based on the one or more transistors 330 using at least a portion of the voltage during activation of the one or more transistors 330. In some implementations, the transistors 330 may be TFTs functioning as word line decoders (e.g., TFT-based word line decoding circuitry). In some examples, the decoding circuitry may include one or more other stages besides the first stage 310 and the second stage 315 to support decoding for the memory cells. For example, the decoding circuitry may include one or more components between the charging transistor 325 and the second stage 315, which may be configured to support activating word lines 305 of the circuit 300.

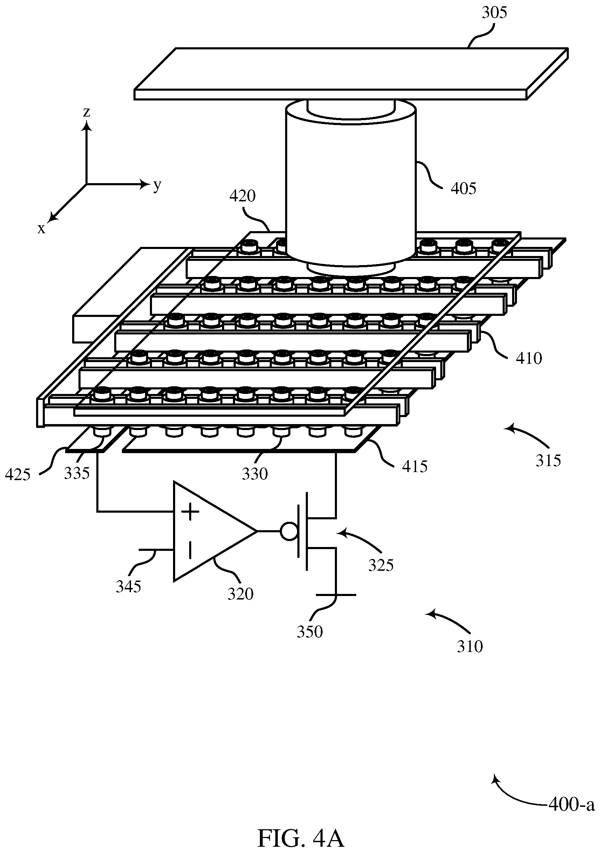

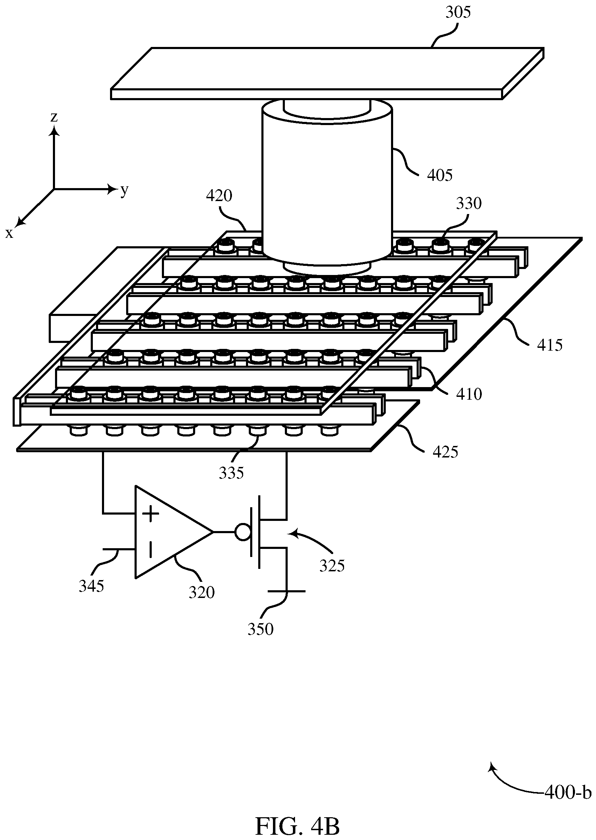

Techniques described herein provide for one or more transistors from among multiple transistors positioned under an array of memory cells to be used as a sensing transistor 335 which may provide for the circuit 300 to be a closed-loop feedback circuity. For example, the circuit 300 may include one or more sensing transistors 335 configured to sense the voltage of the one or more word lines 305. The one or more sensing transistors 335 may be coupled with the one or more word lines 305 via an activation line 340. In some such examples, the activation line 340 may be coupled with the second stage 315 such that the transistors 330 may be configured to supply the voltage to the one or more word lines 305 via the activation line 340. The one or sensing transistors 335 may be configured to sense the voltage of the activation line 340 based on (e.g., after, in response to) the transistors 330 supplying the voltage to the activation line 340 for activating the one or more word lines 305. Thus, the one or more sensing transistors 335 may sense the actual voltage received by the one or more word lines 305. In some implementations, the one or more sensing transistors 335 may be TFTs. In some such implementations, the one or more sensing transistors 335 may be spare TFTs of the set of transistors 330. For example, the one or sensing transistors 335 may be a row of the set of transistors 330 or a column of the set of transistors 330 that are allocated for sensing purposes, as described in further detail elsewhere herein, including with reference to FIGs. 4A and 4B.

The amplifier 320 may be configured to receive the voltage sensed by the one or more sensing transistors 335. The amplifier 320 may also receive an indication of a target voltage 345 (e.g., a desired voltage) for activating the one or more word lines 305. For example, the target voltage 345 may be a target activation voltage corresponding to a voltage at which the word lines 305 may be correctly activated. The amplifier 320 may compare the voltage received from the one or more sensing transistors 335 and the target voltage 345, such that the amplifier may determine a difference between the actual voltage received at the word lines 305 and the target voltage 345 for activating the word lines 305. The amplifier 320 may be configured to output the difference (e.g., the target voltage 345 ± the difference) to the charging transistor 325. For example, the amplifier 320 may amplify the difference between the voltage received from the one or more sensing transistors 335 and the target voltage 345, then output the amplified difference to the charging transistor 325. In some cases, the amplifier 320 may be configured to store an indication of the difference until an access operation is initiated.

In some cases, a magnitude of the difference may be based on activating the set of transistors 330, the charging transistor 325, and the voltage sensed by the one or more sensing transistors 335. In some examples, the actual voltage received at the one or more word lines 305 may be less than the target voltage 345, thus the amplifier 320 may output a combination of the target voltage 345 and the difference. In some such examples, the charging transistor 325 may supply a relatively higher voltage to the one or more word lines 305 based on the monitored demand. In other examples, the actual voltage received at the one or more word lines 305 may be greater than the target voltage 345, thus the amplifier 320 may output the difference subtracted from the target voltage 345. In some such examples, the charging transistor 325 may supply a relatively lower voltage to the one or more word lines 305, based on the monitored demand.

The charging transistor 325 may be configured to receive a supply voltage and output a voltage to the second stage 315 of the decoding circuitry. For example, the charging transistor 325 may be coupled with a power source 350 and configured to receive the supply voltage from the power source 350. Likewise, the charging transistor 325 may be coupled with the set of transistors 330 and configured to output the voltage to the set of transistors 330. Additionally, the charging transistor 325 may be coupled with the amplifier 320 and configured to receive an indication of the difference between the voltage received from the one or more sensing transistors 335 and the target voltage 345. In some cases, the charging transistor 325 may include a source, gate, and drain, where the source is coupled with the power source 350, the gate is coupled with the amplifier 320, and the drain is coupled with the set of transistors 330. In some such cases, the charging transistor 325 may receive the supply voltage from the power source 350, and upon the supply voltage reaching a voltage associated with the difference indicated from the charging transistor 325, the charging transistor 325 may output the voltage to the set of transistors 330. In some examples, the charging transistor 325 may be a PMOS transistor, such that the charging transistor 325 may not be associated with having a threshold voltage for activating the charging transistor 325. In other examples, the charging transistor 325 may be an NMOS transistor, such that the charging transistor 325 may be associated with having a threshold voltage for activating the charging transistor 325. In some such examples, the voltage supplied to the second stage 315 may be increased (e.g., after sensing) due to a portion of the voltage being used for activating the charging transistor 325.

In some cases, an access operation for the one or more memory cells supported by the circuit 300 may include the power source 350 outputting a supply voltage to the charging transistor 325. The amplifier 320 may output an indication of the target voltage 345 to at gate of the charging transistor 325 at the same time as or in an overlapping time period with the application of the supply voltage to the source of the charging transistor 325. The charging transistor may output a voltage to the set of transistors 330 based on the supply voltage satisfying the target voltage 345. The set of transistors 330 may output the voltage to the one or more word lines 305 (e.g., via the activation line 340) for activating the one or more word lines 305. Then, the sensing transistor 335 may sense the actual voltage received at the one or more word lines 305 via the activation line 340. The sensing transistor 335 may output the actual voltage to the amplifier 320, and the amplifier 320 may compare the actual voltage with the desired voltage 345. The amplifier 320 may determine the difference between the actual voltage and the desired voltage 345 and output an indication of the difference to the charging transistor 325. On a subsequent access operation, the power source 350 may output the supply voltage to the charging transistor 325, and the amplifier 320 may concurrently output the indication of the difference to the charging transistor 325. The charging transistor 325 may output a new voltage to the set of transistors 330 based on the supply voltage satisfying the difference. The set of transistors 330 may output the voltage to the one or more word lines 305 (e.g., via the activation line 340) for activating the one or more word lines 305.

Implementing the circuit 300 for performing access operations may enable a memory device to perform access operations with greater reliability and accuracy. Because the one or more sensing transistors 335 may sense the actual voltage received at the word lines 305, the memory device may modulate the voltage supplied to the word lines 305 such that the word lines 305 receive the appropriate voltage. For example, during a variable current draw due to memory cell leakage or memory cell switching events, the circuit 300 may support modulating the voltage provided to the word lines 305 based on the variable current draw. That is, modulating the voltage dynamically based on detected conditions of the circuit 300 may enable greater accuracy for performing access operations. Additionally, or alternatively, providing the appropriate voltage to the word lines 305 may prevent voltage overshoot associated with high power consumption. Thus, the circuit 300 may support greater power efficiency and lower overall consumption.

**FIGs. 4A** **and** **4B** show examples of a decoding architecture 400-a and a decoding architecture 400-b that support voltage control using transistor sensing in accordance with examples as disclosed herein. The decoding architectures 400 (e.g., the decoding architecture 400-a, the decoding architecture 400-b) may be implemented at a memory device, which may be an example of a memory device 100 as described with reference to FIG. 1. Likewise, the decoding architectures 400 may illustrate portions of a circuit, which may be an example of a circuit 300, as described with reference to FIG. 3. For example, the decoding architectures 400 may illustrate operations associated with activating one or more word lines 305, as described with reference to FIG. 3. For illustrative purposes, aspects of the decoding architectures 400 may be described with reference to an x-direction, a y-direction, and a z-direction of the illustrated coordinate systems. For example, FIGs. 4A and 4B illustrate the decoding architectures 400 from trimetric views. The decoding architectures 400 illustrate circuit elements associated with accessing memory cells of a memory device.

The decoding architectures 400 may include one or more word lines 305 configured to access a set of memory cells. In some cases, the one or more word lines 305 may be word line combs each including a set of word line fingers, where each word line finger is associated with a subset of memory cells. In some examples, the memory cells may be associated with a tier of the decoding architecture 400. Additionally, or alternatively, each memory cell in the set of memory cells may be coupled with a common word line 305 and a respective pillar of a set of pillars. The one or more word lines 305 may be coupled with decoding circuitry beneath the one or more word lines 305 through one or more through array vias (TAVs) 405. In some cases, the TAVs 405 may be examples of an activation line 340, as described with reference to FIG. 3. The decoding circuitry may include a first stage 310 of the decoding circuitry and a second stage 315 of the decoding circuitry. The first stage 310 may include an amplifier 320 and a charging transistor 325, and the second stage 315 may include a set of transistors 330. The amplifier 320 may be configured to receive a target voltage 345 for activating the word lines 305 and an actual voltage received at the word lines 305 (e.g., from one or more sensing transistors 335). The amplifier 320 may be configured to output a difference between the target voltage 345 and the actual voltage to the charging transistor 325. The charging transistor 325 may receive a supply voltage from a power source 350 and output a voltage to the set of transistors 330 based on receiving the difference from the amplifier 320.

The second stage 315 of the decoding circuitry may include the set of transistors 330, which may be coupled with control lines 410 associated with activating the set of transistors 330. In some cases, the set of transistors 330 may connect one or more word lines with pillars associated with accessing the set of memory cells. In some cases, the set of transistors 330 may connect one or more bit lines with pillars associated with accessing the set of memory cells. The second stage 315 may include one or more conductive planes 415 and 425 coupled with the set of transistors 330. For example, the control lines 410 may be coupled with gates of the transistors 330, the plane 415 may be coupled with a source of the transistors 330, and the plane 425 may be coupled with a drain of the transistors 330. The plane 415 may be configured to receive voltages from the charging transistor (e.g., based on the difference indicated by the amplifier 320) and apply the voltages to the transistors 330, where a transistor 330 may be activated based on the voltage exceeding a gate voltage indicated via the respective control lines 410. The plane 425 may be configured to receive the voltages from the transistors 330 for activating the word lines 305, where the voltages may be transferred from the plane 425 to the word lines 305 via the TAVs 405.

The decoding architecture 400 may include sensing transistors 335 configured to sense the actual voltage received at the word lines 305 during an access operation. The sensing transistors 335 may be coupled with the amplifier 320 and configured to indicate the actual voltage to the amplifier 320 for outputting the difference. In some cases, the sensing transistors 335 may be coupled with the amplifier 320 via a plane 425. The sensing transistors 335 may be spare transistors of the set of transistors 330. For example, one or more transistors 330 of the set of transistors 330 may be redundant for decoding (e.g., spare transistors), such that the one or more transistors 330 may instead be used for sensing. However, the sensing transistors 335 may not be configured to provide voltages for activating the word lines 305. As illustrated in FIG. 4A, in some cases, the sensing transistors 335 may be a column of the set of transistors 330. For example, the sensing transistors 335 may be a subset of the transistors 330 extending perpendicular to the word lines 305 or a row of memory cells (e.g., parallel to a column of memory cells). As illustrated in FIG. 4B, in other cases, the sensing transistors 335 may be a row of the set of transistors 330. For example, the sensing transistors 335 may be a subset of the transistors 330 extending parallel to the word lines 305 or a row of memory cells. In some cases, the sensing transistors 335 may be partitioned from the set of transistors 330 (e.g., based on the different conductive planes 425 and 415).

Implementing the decoding architecture 400 for performing access operations may enable a memory device to perform the access operations with greater reliability and accuracy. Because the one or more sensing transistors 335 may sense the actual voltage received at the word lines 305, the memory device may modulate the voltage supplied to the word lines 305 such that the word lines 305 receive the appropriate voltage. That is, modulating the voltage dynamically based on detected conditions of the decoding architecture 400 may enable greater accuracy for performing access operations. Additionally, or alternatively, providing the appropriate voltage to the word lines 305 may prevent voltage overshoot associated with high power consumption, thereby supporting greater power efficiency and lower overall consumption.

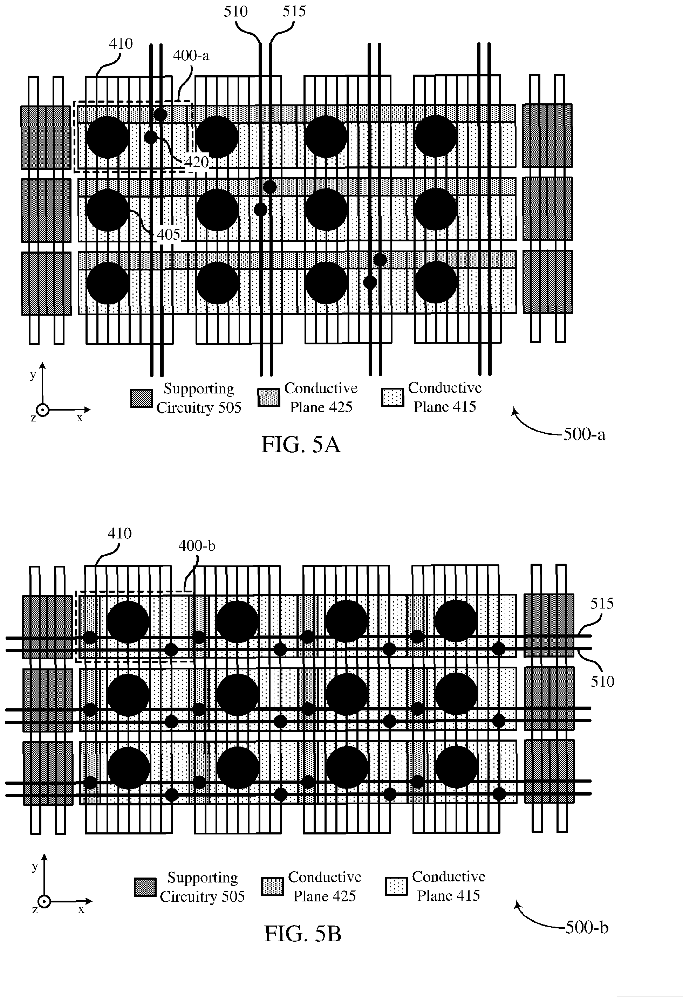

**FIGs. 5A and 5B** show examples of a decoding architecture 500-a and a decoding architecture 500-b that support voltage control using transistor sensing in accordance with examples as disclosed herein. The decoding architectures 500 (e.g., the decoding architecture 500-a, the decoding architecture 500-b) may be implemented at a memory device, which may be an example of a memory device 100 as described with reference to FIG. 1. Likewise, the decoding architectures 500 may illustrate a memory device architecture which may include or otherwise implement a circuit, which may be an example of a circuit 300, as described with reference to FIG. 3. For example, the decoding architectures 500 may illustrate operations associated with activating one or more word lines 305, as described with reference to FIG. 3. For illustrative purposes, aspects of the decoding architectures 500 may be described with reference to an x-direction, a y-direction, and a z-direction of the illustrated coordinate systems. For example, FIGs. 5A and 5B illustrate the decoding architectures 500 from top views in an xy-plane, where the components extend some distance along the z-direction (e.g., out of the page). The decoding architectures 500 illustrate circuit elements associated with accessing memory cells of a memory device.

FIGs. 5A and 5B illustrate the decoding architectures 500 from a more wholistic view of the decoding structure implemented at a memory device. For example, FIGs. 4A and 4B illustrate a decoding architecture 400-a and a decoding architecture 400-b, respectively, which may form a portion of the decoding architecture 500-a and the decoding architecture 500-b, respectively. That is, the decoding architecture 500-a may include repeated instances (e.g., a series, a set) of the decoding architecture 400-a, as illustrated by the dashed rectangle in FIG. 5A, and the decoding architecture 500-b may include repeated instances of the decoding architecture 400-b, as illustrated by the dashed rectangle in FIG. 5B. For example, each decoding architecture 400-a includes a conductive plane 425 extending along the x-direction, where the conductive plane 425 is coupled with a subset of sensing transistors (e.g., sensing transistors 335), such that the decoding architecture 400-a includes a column of sensing transistors coupled with the conductive plane 425. Thus, the decoding architecture 500-a illustrates the conductive planes 425 extending along the x-direction, and thereby includes columns of sensing transistors coupled with the conductive planes 425. In another example, each decoding architecture 400-b includes the conductive plane 425 extending along the y-direction, where the conductive plane 425 is coupled with a subset of sensing transistors (e.g., sensing transistors 335), such that the decoding architecture 400-b includes a row of sensing transistors coupled with the conductive plane 425. Thus, the decoding architecture 500-b illustrates the conductive planes 425 extending along the y-direction, and thereby includes rows of sensing transistors coupled with the conductive planes 425.

The decoding architectures 500 illustrate control lines 410 extending along the y-direction between multiple instances of the decoding architectures 400. For example, the control lines 410 may extend through the decoding architecture 400-a to another instance of the decoding architecture adjacent to the decoding architecture 400-a in the y-direction. In some cases, each decoding architecture 400 may include a TAV 405 coupled with word lines 305 of the respective decoding architecture 400 such that adjacent decoding architecture 400 in the x-direction do not include TAVs 405 on the same control lines 410. In some cases, the control lines 410 may be coupled with a set of transistors (e.g., transistors 330) associated with each instance of the decoding architecture 400. The control lines 410 may be located below the word lines 305 along the z-direction. Additionally, the control lines 410 associated with each instance of the decoding architecture may be coupled with a difference respective word line 305 based on a respective TAV 405.

The decoding architectures 500 may include control lines 510 and 515 extending between multiple instances of the decoding architecture 400. For example, in FIG. 5A, the control lines 510 and 515 may extend along the y-direction between adjacent instances of the decoding architecture 400. In FIG. 5B, the control lines 510 and 515 may extend along the x-direction between adjacent instances of the decoding architecture 400. The control lines 510 and 515 may be beneath the transistors (e.g., transistors 330, transistors 335), such that the control lines 510 and 515 may be coupling the transistors (e.g., sources of the transistors) with CMOS circuitry below the decoding architectures 500. The control lines 510 may be coupled with the transistors 330, and the control lines 515 may be coupled with the transistors 335. For example, because the transistors 335 are a column of the transistors 330, as in FIG. 4A, the control lines 510 and 515 may extend along the y-direction to facilitate coupling. Likewise, because the transistors 335 are a row of the transistors 330, as in FIG. 4B, the control lines 510 and 515 may extend along the x-direction. In some such examples, the control lines 510 and 515 may couple with the transistors 330 and 335 via connections 420. In some cases, the control lines 510 may be configured to support driving the transistors 335 for activating word lines 305 of the decoding architecture 500. In some such cases, the control lines 515 may be configured to support sensing via the transistors 335.

The decoding architectures 500 also include additional supporting circuitry 505 adjacent to the instances of the decoding architectures 400 in the x-direction. The supporting circuitry 505 may be configured to connect a word line 305 with CMOS circuitry below the decoding architectures 500. In some cases, the supporting circuitry 505 may be associated with an additional stage of decoding circuitry. For example, the supporting circuitry 505 may extend along the y-direction at least the length of the decoding architecture 500. In some cases, the supporting circuitry 505 may be associated with a staircase region of the decoding architecture 500. For example, a staircase region including circuitry associated with providing additional decoding support may be located above the supporting circuitry 505. The decoding architectures 500 may also include CMOS circuitry under the decoding architectures 500 configured to support decoding and additional processes of a memory device implementing the decoding architectures 500.

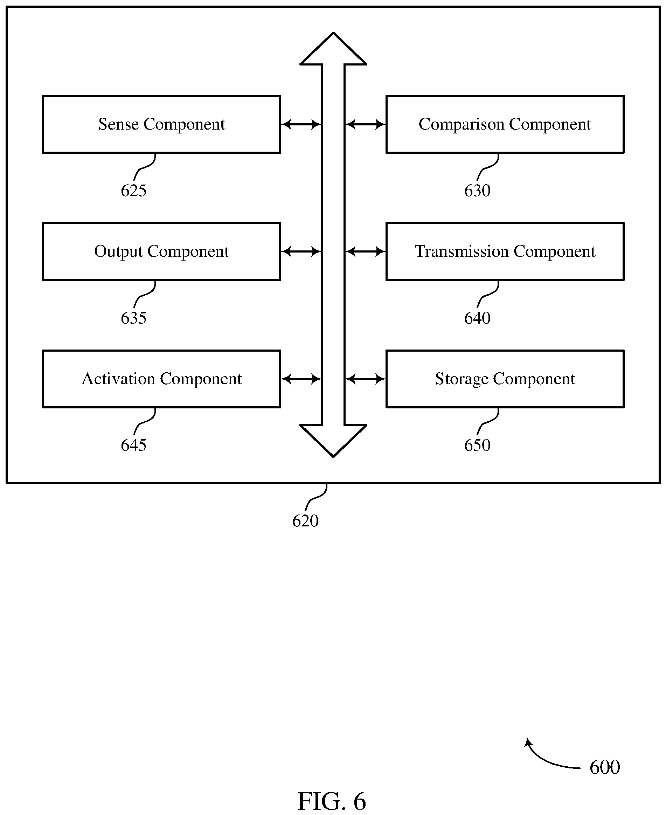

**FIG.** 6 shows a block diagram 600 of a memory device 620 that supports voltage control using transistor sensing in accordance with examples as disclosed herein. The memory device 620 may be an example of aspects of a memory device as described with reference to FIGs. 1 through 4. The memory device 620, or various components thereof, may be an example of means for performing various aspects of voltage control using transistor sensing as described herein. For example, the memory device 620 may include a sense component 625, a comparison component 630, an output component 635, a transmission component 640, an activation component 645, a storage component 650, or any combination thereof. Each of these components, or components of subcomponents thereof (e.g., one or more processors, one or more memories), may communicate, directly or indirectly, with one another (e.g., via one or more buses).

The sense component 625 may be configured as or otherwise support a means for sensing, by one or more first transistors, a first voltage associated with one or more word lines of a memory array. The comparison component 630 may be configured as or otherwise support a means for comparing, by a first stage of decoding circuitry based at least in part on the first voltage, the first voltage with a target word line activation voltage. The output component 635 may be configured as or otherwise support a means for outputting, by the first stage of decoding circuitry based at least in part on comparing the first voltage with the target word line activation voltage, a second voltage to a second stage of decoding circuitry, the second voltage associated with activating one or more of the first stage of decoding circuitry, the second stage of decoding circuitry, or the one or more word lines of the memory array.

In some examples, the transmission component 640 may be configured as or otherwise support a means for transmitting, from the one or more first transistors to the first stage of decoding circuitry, the first voltage based at least in part on sensing the first voltage, where comparing the first voltage with the target word line activation voltage is based at least in part on receiving the first voltage at the first stage of decoding circuitry.

In some examples, outputting the second voltage to the second stage of the decoding circuitry is based at least in part on a supply voltage applied to a source of a second transistor and the second voltage applied to a gate of the second transistor.

In some examples, the activation component 645 may be configured as or otherwise support a means for activating, by the second stage of decoding circuitry, the one or more word lines based at least in part on receiving the second voltage from the first stage of decoding circuitry.

In some examples, the storage component 650 may be configured as or otherwise support a means for storing an indication of the second voltage based at least in part on comparing the first voltage with the target word line activation voltage.

In some examples, the second voltage includes the first voltage and a third voltage associated with activating the second stage of the decoding circuitry.

In some examples, the described functionality of the memory device 620, or various components thereof, may be supported by or may refer to at least a portion of at least one processor, where such at least one processor may include one or more processing elements (e.g., a controller, a microprocessor, a microcontroller, a digital signal processor, a state machine, discrete gate logic, discrete transistor logic, discrete hardware components, or any combination of one or more of such elements). In some examples, the described functionality of the memory device 620, or various components thereof, may be implemented at least in part by instructions (e.g., stored in memory, non-transitory computer-readable medium) executable by such at least one processor.

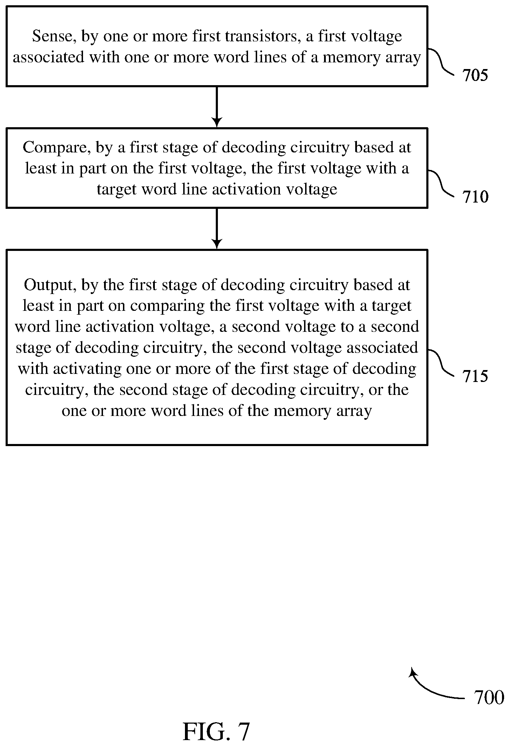

**FIG. 7** shows a flowchart illustrating a method 700 that supports voltage control using transistor sensing in accordance with examples as disclosed herein. The operations of method 700 may be implemented by a memory device or its components as described herein. For example, the operations of method 700 may be performed by a memory device as described with reference to FIGs. 1 through 6. In some examples, a memory device may execute a set of instructions to control the functional elements of the device to perform the described functions. Additionally, or alternatively, the memory device may perform aspects of the described functions using special-purpose hardware.

At 705, the method may include sensing, by one or more first transistors, a first voltage associated with one or more word lines of a memory array. In some examples, aspects of the operations of 705 may be performed by a sense component 625 as described with reference to FIG. 6.

At 710, the method may include comparing, by a first stage of decoding circuitry based at least in part on the first voltage, the first voltage with a target word line activation voltage. In some examples, aspects of the operations of 710 may be performed by a comparison component 630 as described with reference to FIG. 6.

At 715, the method may include outputting, by the first stage of decoding circuitry based at least in part on comparing the first voltage with the target word line activation voltage, a second voltage to a second stage of decoding circuitry, the second voltage associated with activating one or more of the first stage of decoding circuitry, the second stage of decoding circuitry, or the one or more word lines of the memory array. In some examples, aspects of the operations of 715 may be performed by an output component 635 as described with reference to FIG. 6.

In some examples, an apparatus as described herein may perform a method or methods, such as the method 700. The apparatus may include features, circuitry, logic, means, or instructions (e.g., a non-transitory computer-readable medium storing instructions executable by a processor), or any combination thereof for performing the following aspects of the present disclosure:
Aspect 1: A method, apparatus, or computer-readable medium including operations, features, circuitry, logic, means, or instructions, or any combination thereof for sensing, by one or more first transistors, a first voltage associated with one or more word lines of a memory array; comparing, by a first stage of decoding circuitry based at least in part on the first voltage, the first voltage with a target word line activation voltage; and outputting, by the first stage of decoding circuitry based at least in part on comparing the first voltage with the target word line activation voltage, a second voltage to a second stage of decoding circuitry, the second voltage associated with activating one or more of the first stage of decoding circuitry, the second stage of decoding circuitry, or the one or more word lines of the memory array.
Aspect 2: The method, apparatus, or computer-readable medium of aspect 1, further including operations, features, circuitry, logic, means, or instructions, or any combination thereof for transmitting, from the one or more first transistors to the first stage of decoding circuitry, the first voltage based at least in part on sensing the first voltage, where comparing the first voltage with the target word line activation voltage is based at least in part on receiving the first voltage at the first stage of decoding circuitry.
Aspect 3: The method, apparatus, or computer-readable medium of any of aspects 1 through 2, where outputting the second voltage to the second stage of the decoding circuitry is based at least in part on a supply voltage applied to a source of a second transistor and the second voltage applied to a gate of the second transistor.
Aspect 4: The method, apparatus, or computer-readable medium of any of aspects 1 through 3, further including operations, features, circuitry, logic, means, or instructions, or any combination thereof for activating, by the second stage of decoding circuitry, the one or more word lines based at least in part on receiving the second voltage from the first stage of decoding circuitry.
Aspect 5: The method, apparatus, or computer-readable medium of any of aspects 1 through 4, further including operations, features, circuitry, logic, means, or instructions, or any combination thereof for storing an indication of the second voltage based at least in part on comparing the first voltage with the target word line activation voltage.
Aspect 6: The method, apparatus, or computer-readable medium of any of aspects 1 through 5, where the second voltage includes the first voltage and a third voltage associated with activating the second stage of decoding circuitry.

It should be noted that the methods described herein describe possible implementations, and that the operations and the steps may be rearranged or otherwise modified and that other implementations are possible. Further, portions from two or more of the methods may be combined.

An apparatus is described. The following provides an overview of aspects of the apparatus as described herein:
Aspect 7: A memory device, including: a memory array including a plurality of word lines operable to couple with a plurality of memory cells; and decoding circuitry coupled with the memory array and configured to activate the plurality of word lines, the decoding circuitry including: one or more first transistors coupled with one or more word lines of the plurality of word lines and configured to a sense a first voltage associated with the one or more word lines; a first stage of the decoding circuitry coupled with the one or more first transistors and configured to: compare the first voltage with a target word line activation voltage; and output, to a second stage of the decoding circuitry, a second voltage based at least in part on comparison of the first voltage with the target word line activation voltage; and the second stage of the decoding circuitry coupled with the first stage of the decoding circuitry and the one or more word lines, the second stage of the decoding circuitry configured to activate the one or more word lines based at least in part on the second voltage.
Aspect 8: The memory device of aspect 7, where the first stage of the decoding circuitry includes: an amplifier coupled with the one or more first transistors, the amplifier configured to output the second voltage based at least in part on the comparison of the first voltage and the target word line activation voltage; and a second transistor coupled with an output of the amplifier and the second stage of the decoding circuitry, the second transistor configured to supply the second voltage to the second stage of the decoding circuitry.
Aspect 9: The memory device of aspect 8, where the second transistor is further configured to: output the second voltage to the second stage of the decoding circuitry based at least in part on a supply voltage applied to a source of the second transistor and the second voltage applied to a gate of the second transistor.
Aspect 10: The memory device of any of aspects 8 through 9, where the amplifier is further configured to: store an indication of the second voltage.
Aspect 11: The memory device of any of aspects 8 through 10, where the second transistor includes a PMOS transistor.
Aspect 12: The memory device of any of aspects 7 through 11, where: the one or more first transistors each include a thin film transistor; and the second stage of the decoding circuitry includes a plurality of thin film transistors.
Aspect 13: The memory device of any of aspects 7 through 12, where the decoding circuitry further includes: a plurality of first transistors, where the one or more first transistors are one of the plurality of first transistors, and where the plurality of first transistors are associated with a row or column of the second stage of the decoding circuitry.
Aspect 14: The memory device of any of aspects 7 through 13, where the second voltage is associated with activating one or more of the first stage of the decoding circuitry, the second stage of the decoding circuitry, or the one or more word lines.
Aspect 15: The memory device of any of aspects 7 through 14, where the plurality of word lines are operable to activate the plurality of memory cells based at least in part on the second voltage.
Aspect 16: The memory device of any of aspects 7 through 15, where the second voltage includes the first voltage and a third voltage associated with activating the second stage of the decoding circuitry.

An apparatus is described. The following provides an overview of aspects of the apparatus as described herein:
Aspect 17: A memory device, including: a set of memory cells in a tier, each memory cell in the set of memory cells coupled with a common word line and a respective pillar of a set of pillars; decoding circuitry positioned below the set of memory cells and including a set of transistors; a first subset of transistors of the set of transistors, each transistor of the first subset of transistors coupled with the common word line and a second transistor, the first subset of transistors configured to activate the common word line based at least in part on a first voltage output from the second transistor; and a second subset of transistors of the set of transistors, each transistor of the second subset of transistors coupled with the common word line and an amplifier, the second subset of transistors configured to provide a second voltage of the common word line to the amplifier.
Aspect 18: The memory device of aspect 17, where the first subset of transistors are coupled with the set of memory cells based at least in part on one or more through silicon vias extending between the decoding circuitry and the set of memory cells.
Aspect 19: The memory device of any of aspects 17 through 18, where the second subset of transistors are associated with a row of the set of transistors, the row of transistors extends along a direction parallel to a row of the set of memory cells.
Aspect 20: The memory device of any of aspects 17 through 19, where the second subset of transistors are associated with a column of the set of transistors, the column of transistors extends along a direction parallel to a column of the set of memory cells.
Aspect 21: The memory device of any of aspects 17 through 20, where the set of transistors are positioned between the set of memory cells and circuitry under the memory device, the circuitry under the memory device including the second transistor and the amplifier.

Information and signals described herein may be represented using any of a variety of different technologies and techniques. For example, data, instructions, commands, information, signals, bits, or symbols of signaling that may be referenced throughout the above description may be represented by voltages, currents, electromagnetic waves, magnetic fields or particles, optical fields or particles, or any combination thereof. Some drawings may illustrate signals as a single signal; however, the signal may represent a bus of signals, where the bus may have a variety of bit widths.

The terms "electronic communication," "conductive contact," "connected," and "coupled" may refer to a relationship between components that supports the flow of signals between the components. Components are considered in electronic communication with (or in conductive contact with or connected with or coupled with) one another if there is any conductive path between the components that can, at any time, support the flow of signals between the components. At any given time, the conductive path between components that are in electronic communication with each other (or in conductive contact with or connected with or coupled with) may be an open circuit or a closed circuit based on the operation of the device that includes the connected components. The conductive path between connected components may be a direct conductive path between the components or the conductive path between connected components may be an indirect conductive path that may include intermediate components, such as switches, transistors, or other components. In some examples, the flow of signals between the connected components may be interrupted for a time, for example, using one or more intermediate components such as switches or transistors.

The term "coupling" (e.g., "electrically coupling") may refer to condition of moving from an open-circuit relationship between components in which signals are not presently capable of being communicated between the components over a conductive path to a closed-circuit relationship between components in which signals are capable of being communicated between components over the conductive path. When a component, such as a controller, couples other components together, the component initiates a change that allows signals to flow between the other components over a conductive path that previously did not permit signals to flow.

The term "isolated" refers to a relationship between components in which signals are not presently capable of flowing between the components. Components are isolated from each other if there is an open circuit between them. For example, two components separated by a switch that is positioned between the components are isolated from each other when the switch is open. When a controller isolates two components, the controller affects a change that prevents signals from flowing between the components using a conductive path that previously permitted signals to flow.

The devices discussed herein, including a memory array, may be formed on a semiconductor substrate, such as silicon, germanium, silicon-germanium alloy, gallium arsenide, gallium nitride, etc. In some examples, the substrate is a semiconductor wafer. In other examples, the substrate may be a silicon-on-insulator (SOI) substrate, such as silicon-on-glass (SOG) or silicon-on-sapphire (SOP), or epitaxial layers of semiconductor materials on another substrate. The conductivity of the substrate, or sub-regions of the substrate, may be controlled through doping using various chemical species including, but not limited to, phosphorus, boron, or arsenic. Doping may be performed during the initial formation or growth of the substrate, by ion-implantation, or by any other doping means.

A switching component or a transistor discussed herein may represent a field-effect transistor (FET) and comprise a three terminal device including a source, drain, and gate. The terminals may be connected to other electronic elements through conductive materials, e.g., metals. The source and drain may be conductive and may comprise a heavily-doped, e.g., degenerate, semiconductor region. The source and drain may be separated by a lightly-doped semiconductor region or channel. If the channel is n-type (i.e., majority carriers are electrons), then the FET may be referred to as a n-type FET. If the channel is p-type (i.e., majority carriers are holes), then the FET may be referred to as a p-type FET. The channel may be capped by an insulating gate oxide. The channel conductivity may be controlled by applying a voltage to the gate. For example, applying a positive voltage or negative voltage to an n-type FET or a p-type FET, respectively, may result in the channel becoming conductive. A transistor may be "on" or "activated" when a voltage greater than or equal to the transistor's threshold voltage is applied to the transistor gate. The transistor may be "off" or "deactivated" when a voltage less than the transistor's threshold voltage is applied to the transistor gate.

The description set forth herein, in connection with the appended drawings, describes example configurations and does not represent all the examples that may be implemented or that are within the scope of the claims. The term "exemplary" used herein means "serving as an example, instance, or illustration," and not "preferred" or "advantageous over other examples." The detailed description includes specific details to provide an understanding of the described techniques. These techniques, however, may be practiced without these specific details. In some instances, well-known structures and devices are shown in block diagram form to avoid obscuring the concepts of the described examples.

In the appended figures, similar components or features may have the same reference label. Further, various components of the same type may be distinguished by following the reference label by a dash and a second label that distinguishes among the similar components. If just the first reference label is used in the specification, the description is applicable to any one of the similar components having the same first reference label irrespective of the second reference label.

The functions described herein may be implemented in hardware, software executed by a processing system (e.g., one or more processors, one or more controllers, control circuitry processing circuitry, logic circuitry), firmware, or any combination thereof. If implemented in software executed by a processing system, the functions may be stored on or transmitted over as one or more instructions (e.g., code) on a computer-readable medium. Due to the nature of software, functions described herein can be implemented using software executed by a processing system, hardware, firmware, hardwiring, or combinations of any of these. Features implementing functions may be physically located at various positions, including being distributed such that portions of functions are implemented at different physical locations.

Illustrative blocks and modules described herein may be implemented or performed with one or more processors, such as a DSP, an ASIC, an FPGA, discrete gate logic, discrete transistor logic, discrete hardware components, other programmable logic device, or any combination thereof designed to perform the functions described herein. A processor may be an example of a microprocessor, a controller, a microcontroller, a state machine, or other types of processors. A processor may also be implemented as at least one of one or more computing devices (e.g., a combination of a DSP and a microprocessor, multiple microprocessors, one or more microprocessors in conjunction with a DSP core, or any other such configuration).

As used herein, including in the claims, "or" as used in a list of items (for example, a list of items prefaced by a phrase such as "at least one of" or "one or more of") indicates an inclusive list such that, for example, a list of at least one of A, B, or C means A or B or C or AB or AC or BC or ABC (i.e., A and B and C). Also, as used herein, the phrase "based on" shall not be construed as a reference to a closed set of conditions. For example, an exemplary step that is described as "based on condition A" may be based on both a condition A and a condition B without departing from the scope of the present disclosure. In other words, as used herein, the phrase "based on" shall be construed in the same manner as the phrase "based at least in part on."

As used herein, including in the claims, the article "a" before a noun is openended and understood to refer to "at least one" of those nouns or "one or more" of those nouns. Thus, the terms "a," "at least one," "one or more," "at least one of one or more" may be interchangeable. For example, if a claim recites "a component" that performs one or more functions, each of the individual functions may be performed by a single component or by any combination of multiple components. Thus, the term "a component" having characteristics or performing functions may refer to "at least one of one or more components" having a particular characteristic or performing a particular function. Subsequent reference to a component introduced with the article "a" using the terms "the" or "said" may refer to any or all of the one or more components. For example, a component introduced with the article "a" may be understood to mean "one or more components," and referring to "the component" subsequently in the claims may be understood to be equivalent to referring to "at least one of the one or more components." Similarly, subsequent reference to a component introduced as "one or more components" using the terms "the" or "said" may refer to any or all of the one or more components. For example, referring to "the one or more components" subsequently in the claims may be understood to be equivalent to referring to "at least one of the one or more components."

Computer-readable media includes both non-transitory computer storage media and communication media including any medium that facilitates transfer of a computer program from one place to another. A non-transitory storage medium may be any available medium that can be accessed by a general purpose or special purpose computer. By way of example, and not limitation, non-transitory computer-readable media can comprise RAM, ROM, electrically erasable programmable read-only memory (EEPROM), compact disk (CD) ROM or other optical disk storage, magnetic disk storage or other magnetic storage devices, or any other non-transitory medium that can be used to carry or store desired program code means in the form of instructions or data structures and that can be accessed by a general-purpose or special-purpose computer, or a general-purpose or special-purpose processor. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, digital subscriber line (DSL), or wireless technologies such as infrared, radio, and microwave are included in the definition of medium. Disk and disc, as used herein, include CD, laser disc, optical disc, digital versatile disc (DVD), floppy disk and Blu-ray disc where disks usually reproduce data magnetically, while discs reproduce data optically with lasers. Combinations of the above are also included within the scope of computer-readable media.

The description herein is provided to enable a person skilled in the art to make or use the disclosure. Various modifications to the disclosure will be apparent to those skilled in the art, and the generic principles defined herein may be applied to other variations without departing from the scope of the disclosure. Thus, the disclosure is not limited to the examples and designs described herein but is to be accorded the broadest scope consistent with the principles and novel features disclosed herein.

## Claims

1. A memory device, comprising:
a memory array comprising a plurality of word lines operable to couple with a plurality of memory cells; and
decoding circuitry coupled with the memory array and configured to activate the plurality of word lines, the decoding circuitry comprising:
one or more first transistors coupled with one or more word lines of the plurality of word lines and configured to a sense a first voltage associated with the one or more word lines;
a first stage of the decoding circuitry coupled with the one or more first transistors and configured to:
compare the first voltage with a target word line activation voltage; and
output, to a second stage of the decoding circuitry, a second voltage based at least in part on comparison of the first voltage with the target word line activation voltage; and
the second stage of the decoding circuitry coupled with the first stage of the decoding circuitry and the one or more word lines, the second stage of the decoding circuitry configured to activate the one or more word lines based at least in part on the second voltage.

2. The memory device of claim 1, wherein the first stage of the decoding circuitry comprises:
an amplifier coupled with the one or more first transistors, the amplifier configured to output the second voltage based at least in part on the comparison of the first voltage and the target word line activation voltage; and
a second transistor coupled with an output of the amplifier and the second stage of the decoding circuitry, the second transistor configured to supply the second voltage to the second stage of the decoding circuitry.

3. The memory device of claim 2, wherein the second transistor is further configured to:
output the second voltage to the second stage of the decoding circuitry based at least in part on a supply voltage applied to a source of the second transistor and the second voltage applied to a gate of the second transistor.

4. The memory device of either of claims 2 or 3, wherein the amplifier is further configured to:
store an indication of the second voltage.

5. The memory device of any of claims 2 to 4, wherein the second transistor comprises a PMOS transistor.

6. The memory device of any preceding claim, wherein:
the one or more first transistors each comprise a thin film transistor; and
the second stage of the decoding circuitry comprises a plurality of thin film transistors.

7. The memory device of any preceding claim, wherein the decoding circuitry further comprises:
a plurality of first transistors, wherein the one or more first transistors are one of the plurality of first transistors, and wherein the plurality of first transistors are associated with a row or column of the second stage of the decoding circuitry.

8. The memory device of any preceding claim, wherein the second voltage is associated with activating one or more of the first stage of the decoding circuitry, the second stage of the decoding circuitry, or the one or more word lines.

9. The memory device of any preceding claim, wherein the plurality of word lines are operable to activate the plurality of memory cells based at least in part on the second voltage.

10. The memory device of any preceding claim, wherein the second voltage comprises the first voltage and a third voltage associated with activating the second stage of the decoding circuitry.

11. A method by a memory device, comprising:
sensing, by one or more first transistors, a first voltage associated with one or more word lines of a memory array;
comparing, by a first stage of decoding circuitry based at least in part on the first voltage, the first voltage with a target word line activation voltage; and
outputting, by the first stage of decoding circuitry based at least in part on comparing the first voltage with the target word line activation voltage, a second voltage to a second stage of decoding circuitry, the second voltage associated with activating one or more of the first stage of decoding circuitry, the second stage of decoding circuitry, or the one or more word lines of the memory array.

12. The method of claim 11, further comprising:
transmitting, from the one or more first transistors to the first stage of decoding circuitry, the first voltage based at least in part on sensing the first voltage, wherein comparing the first voltage with the target word line activation voltage is based at least in part on receiving the first voltage at the first stage of decoding circuitry.

13. The method of either of claims 11 or 12, wherein outputting the second voltage to the second stage of the decoding circuitry is based at least in part on a supply voltage applied to a source of a second transistor and the second voltage applied to a gate of the second transistor.

14. The method of any of claims 11 to 13, further comprising:
activating, by the second stage of decoding circuitry, the one or more word lines based at least in part on receiving the second voltage from the first stage of decoding circuitry.

15. The method of any of claims 11 to 14, further comprising:
storing an indication of the second voltage based at least in part on comparing the first voltage with the target word line activation voltage.
